# EUROPÄISCHE PATENTSCHRIFT

(11) **EP 0 741 838 B1**
(45) Veröffentlichungstag und Bekanntmachung des Hinweises auf die Patenterteilung: **23.09.1998**
(21) Anmeldenummer: 95919963.9
(22) Anmeldetag: 02.06.1995
(51) Int. Cl.: F02P 13/00, F02P 7/03, G02B 6/42, H03K 17/78

(54) **ANORDNUNG ZUM SCHALTEN EINES HOCHSPANNUNGSSCHALTERS MITTELS OPTISCHER ENERGIE**
DEVICE FOR OPERATING A HIGH-TENSION SWITCH BY MEANS OF LIGHT ENERGY
SYSTEME POUR COMMUTER UN INTERRUPTEUR A HAUTE TENSION A L'AIDE D'ENERGIE OPTIQUE

(30) Priorität: 30.11.1994 DE 4442545
(43) Veröffentlichungstag der Anmeldung: 13.11.1996
(73) Patentinhaber: ROBERT BOSCH GMBH, 70442 Stuttgart (DE)
(72) Erfinder: BENEDIKT, Walter, D-70806 Kornwestheim (DE); VOGEL, Manfred, D-71254 Ditzingen (DE); HERDEN, Werner, D-70839 Gerlingen (DE); KONRAD, Johann, D-71732 Tamm (DE)
(86) Internationale Anmeldenummer: DE9500704
(87) Internationale Veröffentlichungsnummer: WO9617169

(56) Entgegenhaltungen:
- WO-A-92/07188
- DE-A- 3 731 393
- US-A- 5 237 969
- PATENT ABSTRACTS OF JAPAN Bd. 014, Nr. 001 (P-985) 08 Januar 1990 & JP,A,01 253 707 (SUMITOMO ELECTRIC IND LTD) 11 Oktober 1989
- PATENT ABSTRACTS OF JAPAN Bd. 015, Nr. 469 (P-1281) 27 November 1991 & JP,A,03 200 918 (RICOH CO LTD) 02 September 1991
- PATENT ABSTRACTS OF JAPAN Bd. 009, Nr. 224 (P-387) 10 September 1985 & JP,A,60 080 810 (MITSUBISHI DENKI KK) 08 Mai 1985
- PATENT ABSTRACTS OF JAPAN Bd. 011, Nr. 330 (M-636) 28 Oktober 1987 & JP,A,62 111 173 (MATSUSHITA ELECTRIC IND CO LTD) 22 Mai 1987

## Beschreibung

### Stand der Technik

Die Erfindung geht aus von einer Anordnung zum Schalten eines Hochspannungsschalters mittels optischer Energie. Aus der EP-0 377 619 ist bereits ein Hochspannungsschalter bekannt, der die Funktion eines Zundspannungsverteilers bei ruhender Hochspannungsverteilung übernimmt. Dieser Hochspannungsschalter ist zwischen dem hochspannungsseitigen Ausgang der Zündspule und der Zündkerze angeordnet und besteht aus Halbleiterelementen, die lichtempfindliche Zonen aufweisen. Die lichtempfindlichen Zonen können von lichtemittierenden Elementen so angesteuert werden, daß sie zu einem vorgegebenen Zeitpunkt, zum Beispiel der Zündfolge entsprechend, durchschalten. Bei der bekannten Anordnung sind Lichtleiter oder Leuchtdioden den lichtempfindlichen Zonen des Hochspannungsschalters gegenüber angeordnet. Eine solche Anordnung benötigt beim Einbau in einer Zündanlage relativ viel Platz. Aus der DE-PS 41 39 823 ist eine Anordnung des lichtemittierenden zum lichtempfindlichen Element bekannt, wobei das lichtemittierende Element eine Leuchtdiode und das lichtübertragende Element aus einer Anzahl von lichtleitenden, miteinander verschmolzenen Glasfasern besteht. Die Querschnitte der Lichteintrittsfläche und der Lichtaustrittsfläche des Lichtleitfaserstabes sind hier der Form des gegenüberliegenden lichtemittierenden bzw. lichtempfindlichen, optoelektronischen Element angepaßt. Hierzu wird die Lichtaustrittsfläche des lichtübertragenden Lichtleitfaserstabes vom ursprünglich runden Querschnitt der Lichteintrittsfläche, der der Leuchtdiode gegenüber liegt, auf einen linienförmigen schmalen Querschnitt geformt, der dem stabförmigen optoelektronischen Halbleiterschalter gegenüberliegt. Zur Verformung des Querschnitts wird der Lichtleitfaserstab erwärmt, geformt und in der neuen Form wieder abgekühlt. Es sind also mehrere Arbeitsschritte notwendig.

### Vorteile der Erfindung

Die erfindungsgemäße Anordnung mit den kennzeichnenden Merkmalen des Hauptanspruchs hat demgegenüber den Vorteil, daß durch ein schräges Heranführen des lichtübertragenden Elementes an die Längserstreckung des Halbleiterschalters eine platzsparende Montage von Halbleiterschalter und lichtübertragenden Element möglich ist.

Durch die in den Unteransprüchen aufgeführten Maßnahmen sind vorteilhafte Weiterbildungen und Verbesserungen der im Hauptanspruch angegebenen Anordnung möglich.

Besonders vorteilhaft ist, daß durch die Verwendung eines stabförmigen Lichtleiters oder Lichtleitfaserstabs als lichtübertragenden Element der Winkel zwischen der Längsachse des lichtübertragenden Elementes und der Längsachse des Hochspannungsschalters sehr klein wählbar ist. Die Abschrägung des lichtübertragenden Elementes an der dem Hochspannungsschalter zugewandten Seite, so daß eine ellipsenförmige Querschnittsfläche entsteht, hat den Vorteil, daß das lichtübertragende Elemente flächig an der Umfangsfläche des Hochspannungsschalters anliegt, wodurch die Lichtenergie sehr genau an vorgebbare Bereiche des Hochspannungsschalters geführt werden kann. Letztendlich sind hierdurch keine zusätzlichen Arbeitsschritte für das Anpassen des Querschnitts des lichtübertragenden Elementes an die Form des Hochspannungsschalters notwendig. Durch die Integration des Hochspannungsschalter mit lichtübertragenden Element in den Zündkerzenstecker kann eine zusätzliche Montage des Hochspannungsschalters mit lichtübertragenden Element beispielsweise auf dem Zylinderkopf oder an der Zündspule entfallen. Damit kann der Zündkerzenstecker fertig vormontiert und dann komplett eingebaut werden, wodurch sich ein besseres Handling ergibt, da nicht noch mehr Einzelteile bei der Motorherstellung zu montieren sind.

### Zeichnung

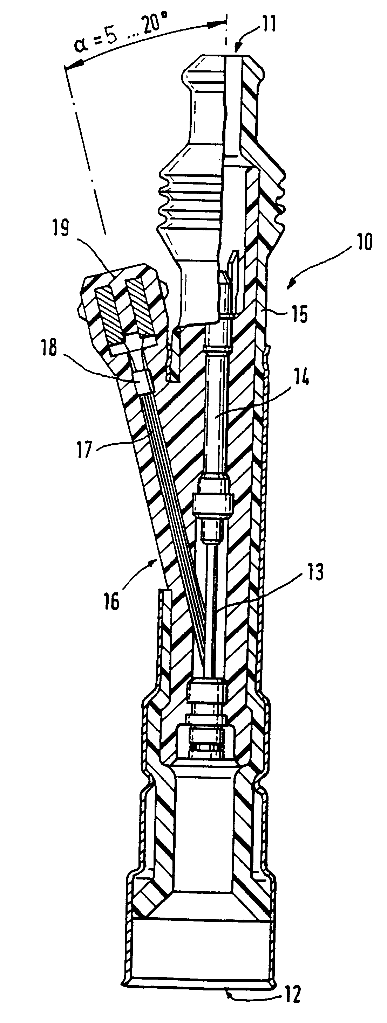

Ein Ausführungsbeispiel der Erfindung ist in der Figur dargestellt und in der nachfolgenden Beschreibung näher erläutert. Die einzige Figur zeigt einen Zündkerzenstecker in geschnittener Darstellung mit der erfindungsgemäßen Anordnung von Hochspannungskippdiode und lichtübertragendem Element.

### Beschreibung des Ausführungsbeispiels

Die Figur zeigt mit dem Bezugszeichen 10 einen Zündkerzenstecker, welcher teilweise in geschnittener Darstellung gezeichnet ist. Dieser Zündkerzenstecker 10 wird an seinem einen Ende, welches mit dem Bezugszeichen 11 versehen ist, mit dem nicht dargestellten Hochspannungskabel verbunden. Das gegenüberliegende Ende 12 des Zündkerzensteckers 10 hat eine zylindrische Öffnung, welche auf die nicht dargestellte Zündkerze aufgesteckt wird. Der innere Aufbau des Zündkerzensteckers entspricht im wesentlichen einem herkömmlichen Zündkerzenstecker. Der einzige Unterschied ist der Einbau des optoelektronischen Hochspannungsschalters 13 in Längsrichtung der rotationssymmetrischen Längsachse des Zündkerzensteckers. Zwischen dem Anschluß für das Hochspannungskabel 11 und dem optoelektronischen Hochspannungsschalter 13 ist ein Entstörwiderstand 14 angeordnet. Der Zündkerzenstecker 10 weist ein rohrförmiges Gehäuse 15 auf. In diesem rohrförmigen Gehäuse 15 ist im Bereich des optoelektronischen Hochspannungsschalters eine Öffnung 16 vorgesehen, durch welche ein Lichtleiter oder ein Lichtleitfaserbündel 17 an den optoelektronischen Halbleiterschalter 13 herangeführt ist. Das am optoelektronischen Hochspannungsschalter anliegende Ende des Lichtleitstabes oder des Lichtleitfaserbündels 17 ist hierbei schräg angeschnitten, so daß die Längsachse des Lichtleitstabes oder des Lichtleitfaserbündels und die rotationssymmetrische Längsachse des Zündkerzensteckers einen Winkel α von 5 bis 20 Grad einschließen. Am vom optoelektronischen Hochspannungsschalter entfernten Ende des Lichtleitstabes oder des Lichtleitfaserbündels 17 ist eine Leuchtdiode 18 montiert, welche über einen entsprechenden Stecker mit einer nicht dargestellten Spannungsversorgung kontaktiert ist. Dabei ist mit dem Bezugszeichen 19 der zündkerzenseitige Teil der Steckverbindung zur Kontaktierung der Leuchtdiode 18 bezeichnet. Der Lichtleiterstab bzw. das Lichtleitfaserbündel 17 ist mit seiner schräg angeschnittenen, ellipsenförmigen Querschnittsfläche nur an einen Teil des optoelektronischen Halbleiterschalters 13 geführt. Damit wird nur ein Teil des opto-elektronischen Halbleiterschalters beleuchtet und mittels Lichtenergie durchgeschaltet.

Die Funktion dieses Zündkerzensteckers entspricht der Funktion eines Zündspannungsverteilers. Wird beim Anlegen der Zündspannung der Hochspannungsschalter nicht beleuchtet, sperrt die gesamte Kippdiodenkaskade. Wird nun entsprechend der Zündfolge die Leuchtdiode 18 angesteuert, so wird der Teil des optoelektronischen Hochspannungsschalters 13, an welchen die Lichtenergie geführt ist, durchgeschaltet und die gesamte Kaskade zündet, so daß die Hochspannung an die Zündkerze durchgeschaltet wird.

Diese gesamte Konstruktion läßt sich in den Zündkerzenstecker integrieren, so daß nur noch eine Kontaktierung der Leuchtdiode 18 erfolgen muß, nachdem die Zündkerzenstecker im Motor eingebaut sind. Selbstverständlich ist diese Integration auch bei anders gearteten Zündkerzensteckern möglich. So kann der Kerzenstecker beispielsweise T-förmig ausgeführt sein, um die Verbindung zum nächstliegenden Zündkerzenstecker herzustellen. Gleichzeitig ist eine vielfältige Ausgestaltung des Anschlusses der Leuchtdiode an den Lichtleiter oder das Lichtleitfaserbündel möglich.

## Patentansprüche

1. Anordnung zum Schalten eines optoelektronischen Hochspannungsschalters (13) mittels optischer Energie, welcher aus einer Anzahl von in Reihe geschalteten steuerbaren Halbleiterelementen besteht, die bei einer vorgegebenen Spannung schlagartig in den leitenden Zustand übergehen, mit einem lichtemittierenden Element und einem lichtübertragenden Element, das zwischen dem lichtelemittierenden Element und dem optoelektronischen Hochspannungsschalter angeordnet ist, dadurch gekennzeichnet, daß der Winkel (α), der von der Längsachse des Hochspannungsschalters (13) und der Längsachse des lichtübertragenden Elementes (17) eingeschlossen wird, zwischen 5 und 20 Grad beträgt.

2. Anordnung nach Anspruch 1, dadurch gekennzeichnet, daß das lichtübertragende Element (17) ein Lichtleiter oder ein Lichtleitfaserstab ist.

3. Anordnung nach Anspruch 1 oder 2, dadurch gekennzeichnet, daß das lichtübertragende Element (17) auf seiner dem Hochspannungsschalter (13) zugewandten Seite eine Abschrägung aufweist, so daß die entstehende ellipsenförmige Querschnittsfläche des lichtübertragenden Elementes an der Umfangsfläche des optoelektronischen Hochspannungsschalters anliegt.

4. Anordnung nach einem der vorherigen Ansprüche, dadurch gekennzeichnet, daß der optoelektronische Hochspannungsschalter (13) im Zündkerzenstecker (10) integriert ist und die Längsachse des Hochspannungsschalter in Richtung der Längsachse des Zündkerzensteckers liegt.

5. Anordnung nach einem der vorherigen Ansprüche, dadurch gekennzeichnet, daß das lichtübertragende Element (17) im Zündkerzenstecker (10) integriert ist.

## Claims

1. Arrangement for switching an optoelectronic high-voltage switch (13) by means of optical energy, which arrangement consists of a number of controllable semiconductor elements connected in series which abruptly change into the conductive state at a predetermined voltage, having a light-emitting element and a light-transmitting element which is arranged between the light-emitting element and the optoelectronic high-voltage switch, characterized in that the angle (α) which is included by the longitudinal axis of the high-voltage switch (13) and the longitudinal axis of the light-transmitting element (17) is between 5 and 20 degrees.

2. Arrangement according to Claim 1, characterized in that the light-transmitting element (17) is a light guide or a light-conducting rod.

3. Arrangement according to Claim 1 or 2, characterized in that the light-transmitting element (17) has, on its side facing the high-voltage switch (13), a bevel such that the ellipsoidal cross-sectional surface of the light-transmitting element which is produced rests on the peripheral surface of the optoelectronic high-voltage switch.

4. Arrangement according to one of the preceding claims, characterized in that the optoelectronic high-voltage switch (13) is integrated in the spark-plug connector (10) and the longitudinal axis of the high-voltage switch lies in the direction of the longitudinal axis of the spark-plug connector.

5. Arrangement according to one of the preceding claims, characterized in that the light-transmitting element (17) is integrated in the spark-plug connector (10).

## Revendications

1. Circuit pour commuter un interrupteur à haute tension (13), optoélectronique par de l'énergie optique,
comprenant un certain nombre d'éléments semi-conducteurs commandés, branchés en série, qui passent à l'état conducteur, brutalement pour une tension prédéterminée,
- avec un élément photoémetteur et un élément phototransmetteur qui sont disposés entre l'élément photoémetteur et l'interrupteur à haute tension optoélectronique,
caractérisé en ce que
l'angle (α) compris entre l'axe longitudinal de l'interrupteur haute tension (13) et l'axe longitudinal de l'élément de transmission de lumière (17) est compris entre 5 et 20 degrés.

2. Dispositif selon la revendication 1,
caractérisé en ce que
l'élément transmettant la lumière (17) est un guide de lumière ou une tige à fibres guide de lumière.

3. Dispositif selon la revendication 1 ou 2,
caractérisé en ce que
l'élément transmettant la lumière (17) comporte sur son côté tourné vers l'interrupteur à haute tension (13), une partie en biais pour que la surface de la section elliptique ainsi formée sur l'élément transmettant la lumière s'applique contre la surface périphérique de l'interrupteur à haute tension optoélectronique.

4. Dispositif selon l'une quelconque des revendications précédentes,
caractérisé en ce que
l'interrupteur à haute tension optoélectronique (13) est intégré au connecteur d'une bougie d'allumage (10) et l'axe longitudinal de l'interrupteur à haute tension est situé dans la direction de l'axe longitudinal du connecteur à bougie.

5. Dispositif selon l'une quelconque des revendications précédentes,
caractérisé en ce que
l'élément transmettant la lumière (17) est intégré au connecteur à bougie (10).
